# EUROPEAN PATENT APPLICATION

(11) **EP 4 481 813 A1**
(43) Date of publication of application: **25.12.2024**
(21) Application number: 23305982.3
(22) Date of filing: 21.06.2023
(51) Int. Cl.: H01L 23/64, H01L 23/482, H01L 23/66, H01L 29/778

(54) **STRUCTURES FOR SUPPRESSING ODD-MODE INSTABILITIES**

(71) Applicant: NXP USA, Inc., Austin TX 78735 (US)
(72) Inventor: Hill, Darren Glen, 5656AG Eindhoven (NL); LEMBEYE, Olivier, 31023 Toulouse (FR)
(74) Representative: Hardingham, Christopher Mark

(57) **Abstract**

An attenuation structure that includes one or more electrically resistive structures is disposed above or below a contact electrode such as a bond pad that is electrically coupled to a first region of an electronic device such as a transistor. The attenuation structure is capacitively coupled to the contact electrode and is configured to cause anisotropic attenuation of time-varying electrical signals applied to the contact electrode. The attenuation structure is characterized by a first attenuation coefficient along a first direction oriented toward the first region and by a second attenuation coefficient that is greater than the first attenuation coefficient along a second direction that is angularly separated from the first direction.

## Description

### FIELD OF THE INVENTION

Embodiments of the subject matter described herein relate to transistor circuits and methods of fabrication of such circuits.

### BACKGROUND OF THE INVENTION

Transistor-based circuits are often used for analog signal processing applications including amplification of radio and microwave-frequency (RFMW) signals and for powerswitching. Advanced transistor designs and high-performance materials such as III-V semiconductors have been used to achieve increased power densities while providing acceptable thermal performance and voltage-induced breakdown characteristics. Transistors for high-performance applications are frequently formed from repeating cells each having separate input, output, and control "fingers" which can be electrically interconnected to allow the cells to be operated in parallel as a single transistor.

### SUMMARY OF THE INVENTION

In an example embodiment, an electronic device includes a transistor formed within a semiconductor substrate having three terminals; a contact electrode that is electrically coupled to a first terminal of the transistor that is an input terminal or an output terminal of the transistor; and an attenuation structure formed above or beneath the contact electrode. The attenuation structure includes a set of resistive stripes that are capacitively coupled to the contact electrode. Each conductive stripe is separated from the contact electrode and separated from each other resistive stripe belonging to the set of resistive stripes by electrically insulating material. Each resistive stripe has a width in a first direction oriented toward the first terminal of the transistor and each is elongated along a second direction that is angularly separated from the second direction. The attenuation structure is configured to cause direction-dependent attenuation of time-varying electrical signals that is higher along the second direction than the first direction.

In another example embodiment, an electronic device includes a first device region, a contact electrode electrically coupled to the first device region, and an attenuation structure. The first device region is configured to receive an input signal or generate an output signal. The attenuation structure includes one or more electrically resistive structures disposed above or below the contact electrode which are capacitively coupled to the contact electrode. The attenuation structure is also configured to cause anisotropic attenuation of time-varying electrical signals applied to the contact electrode. The attenuation structure is characterized by a first attenuation coefficient along a first direction oriented toward the first device region and the attenuation structure is characterized by a second attenuation coefficient that is greater than the first attenuation coefficient along a second direction that is angularly separated from the first direction.

In one or more embodiments, the attenuation structure includes one or more electrically-resistive elements having a width along the first direction that varies along the second direction. It may vary aperiodically along the second direction.

In another example embodiment, a method of forming an electronic device includes forming a contact electrode coupled to a first device region configured to receive an input signal or generate an output signal; and forming an attenuation structure that includes one or more electrically resistive structures disposed above or below the contact electrode and capacitively coupled to the contact electrode. The attenuation structure is configured to cause anisotropic attenuation of time-varying electrical signals applied to the contact electrode. The attenuation structure is characterized by a first attenuation coefficient along a first direction oriented toward the first device region; and the attenuation structure is characterized by a second attenuation coefficient that is greater than the first attenuation coefficient along a second direction that is angularly separated from the first direction.

In one or more embodiemtns, the attenuation structure includes one or more electrically-resistive elements having a width along the first direction that varies along the second direction. It may vary aperiodically along the second direction.

In one or more embodiments, the electronic device includes a high-electron mobility transistor (HEMT) having a channel region formed within a semiconductor heterostructure that is configured to form a conductive two-dimensional electron gas (2DEG); and forming attenuation structure comprises forming first portions of the semiconductor heterostructure where formation of the 2DEG is prevented surrounding second portions of the heterostructure where the 2DEG forms the one or more electrically-resistive structures

### BRIEF DESCRIPTION OF THE SEVERAL VIEWS OF THE DRAWINGS

The present disclosure is illustrated by way of examples, embodiments, and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 is a plan view of an example integrated circuit according to one or more embodiments.
FIG. 2A is a cross-sectional view of an example arrangement of contact pads and resistive stripes according to one or more embodiments.
FIG. 2B is a cross-sectional view of another example arrangement of contact pads and resistive stripes according to one or more embodiments.
FIG. 3 is a cross-sectional view of an example arrangement of contact pads and resistive stripes according to one or more embodiments in which device structures are formed within a semiconductor heterostructure.
FIG. 4A and FIG. 4B are plots of families of current-voltage characteristics ("IV curves") for two transistor devices with an interdigitated layout related to the layout of the electronic device of FIG. 1.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation, and are made with reference to the orientation of the corresponding figure or figures for purposes of illustration.

It will be appreciated that the steps of various processes described herein are non-limiting examples of suitable processes according to embodiments and are for the purposes of illustration. Devices and methods according to embodiments herein may use any suitable processes including those that omit steps described herein, perform those steps and similar steps in different orders, and the like. It will also be appreciated that well-known steps or other well-known process features may be omitted for clarity.

It will be appreciated that, unless explicitly stated otherwise, the term "approximately", when used referring to lateral and vertical dimensions of structures formed using semiconductor fabrication techniques or related techniques means that the dimension or range of dimensions is subject to variations that are within the expected tolerance(s) of the processes used.

Unless otherwise specified, the term "resistive" as used herein refers to structures that exhibit a sheet resistance of at least 0.01 Ohms per square.

It will be understood that references to particular transistor structures (e.g., "source" and "drain") are for purposes of illustration and are intended as nonlimiting examples unless otherwise specified. For instance, it will be understood that the terms source and drain can be interchanged and that features described as forming part of a source terminal can instead form part of a drain terminal. Similarly, it will be understood that references to terminals that are associated with field effect transistors such as "source," "gate," and "drain" can be used to refer to equivalent structures in other types of transistors (e.g., emitter, base, and collector terminals of a bipolar transistor).

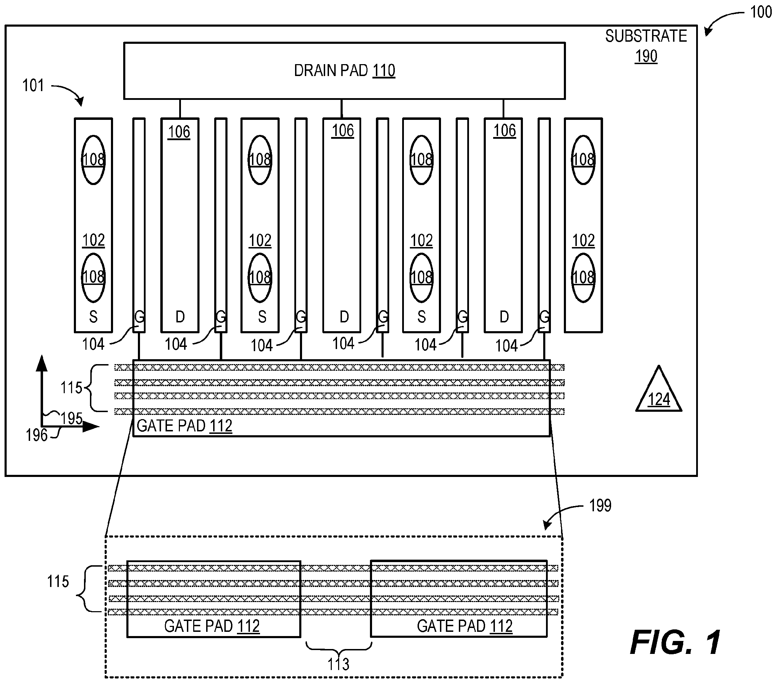

FIG. 1 is a top view of an example integrated circuit according to one or more embodiments. The integrated circuit 100 includes a substrate 190 that is completely or partially composed of a semiconductor material such as silicon, silicon carbide (SiC), or other suitable semiconductor materials. In one or more other embodiments, a substrate such as substrate 190 includes other materials such as sapphire, silicon (Si), gallium nitride (GaN), aluminum nitride (AIN), diamond, boron nitride (BN), poly-SiC, silicon on insulator, gallium arsenide (GaAs), indium phosphide (InP), and/or other substantially insulating or high resistivity materials.

The integrated circuit 100 includes a transistor 101. As shown, the transistor 101 is a field effect transistor (FET) defined by multiple segments forming terminals of the device (sometimes referred to as "fingers"). As shown, the transistor 101 has as source fingers 102 ("S"), gate fingers 104 ("G"), and drain fingers 106 ("D"), where each of the source fingers 102, the gate fingers 104, and the drain fingers 106 are each respectively formed from conductive material (e.g., gold, copper, titanium, aluminum, nickel, and/or the like) disposed at the first surface of the integrated circuit 100. The drain fingers 106 of the transistor 101 are electrically coupled to a drain pad 110 (e.g., a drain bond pad). It will be appreciated that these fingers are coupled to corresponding portions of the transistor 101 operable as a source, gate, and drain.

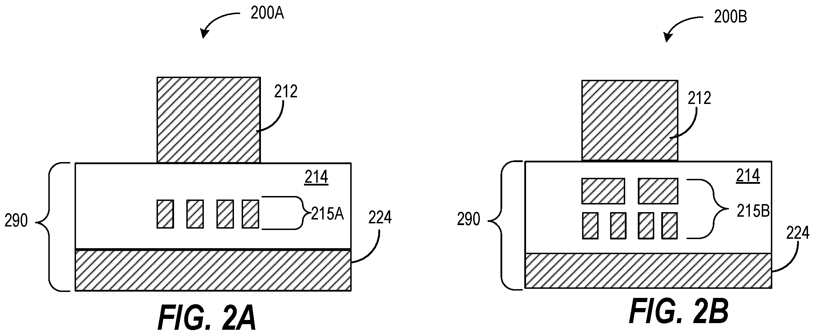

Meanwhile the gate fingers 104 of the transistor 101 may be electrically coupled to a gate pad 112 (e.g., a gate bond pad). For example, each of the gate pad 112 and the drain pad 110 includes conductive material disposed at the first surface of the integrated circuit 100. The source fingers 102 of the transistor 101 may be electrically coupled to a layer of electrically conductive material, sometimes referred to herein as a "reference plane" (the reference terminal 124; e.g., the reference plane 224 of FIG. 2), that is disposed at the second surface of the integrated circuit 100 and that, during operation, is configured to be biased to a reference potential such as a ground voltage.

In one or more embodiments, such as in the example of FIG. 1, source fingers 102 are each coupled to the reference plane by through-substrate vias (TSVs) 108. Each TSV 108 corresponds to an opening (e.g., hole) in the substrate 190 that extends between one of the source fingers 102 and the reference plane and that includes conductive material that provides an electrical connection between that source fingers 102 and the reference plane.

Odd-mode instabilities can occur in devices such as the integrated circuit 100 (e.g., microwave power amplifiers) when the time-varying electric fields in different portions of the amplifier are 180 degrees out of phase with each other. This can occur even in amplifiers which rely on a single transistor die if the die is physically large enough, and the operating frequencies are sufficiently high, such that a lateral resonant loop can be formed between opposite ends of the die. In some instances, such a resonant loop can include leads on the input and/or output sides of the transistor die. If the loop has sufficient gain, the instability can grow into an oscillation with amplitudes capable of damaging or destroying the amplifier.

When optimized for high power handling and high operating frequencies (e.g., 0.5 GHz and above), contact structures such as input and output pads of transistors such as the transistor 101 can have dimensions that are a significant fraction of the wavelength of the maximum oscillation frequency of the transistor. As a result, the instantaneous electric field magnitude at one location (e.g., applied to one of the gate fingers 104) may not be the same at other locations (e.g., one or more adjacent gate fingers 104) at the same instant. Such spatial variations in electric field intensities can result from so-called odd mode instabilities and can occur in the absence of any external AC signals. For example, when a transistor conducts current from source to drain, electrical noise may be sufficient to excite undesired resonance signals which can occur at the fundamental frequency of a resonant loop and/or harmonics of that frequency.

Previous approaches to reducing odd-mode instabilities in devices such as the transistor 101 shown in FIG. 1 include replacing large structures (i.e., those with dimensions that are a comparable to or larger than the wavelength of the maximum oscillation frequency of the transistor) such as bond pads (e.g., a drain pad 110 or a gate pad 112) into smaller segments. These segments are typically electrically coupled to each other using resistive elements. Such approaches can reduce or eliminate odd mode oscillations by attenuating unwanted AC signals propagating from one side of a die to another via resistive losses.

Although such approaches can be effective, they can have disadvantages. As one example, contacts such as the gate pad 112 or drain pad 110 are frequently wirebonded to other components, such as other transistor devices, integrated passive devices, external device package leads, and the like. In such instances, every pad segment must have at least one bond wire (so that the inter-pad resistance is not in series with the signal being amplified). Since optimal performance is obtained when voltages or currents applied to individual portions of a device such as the integrated circuit 100 are balanced, this requires the number of bond wires to be a multiple of the number of pad segments. Additionally, any harmonic termination must be applied to each individual pad segment to avoid losses from inter-pad resistance. As a result of these disadvantages, circuit designers prefer to minimize the use of segmented pads, at the risk of unwanted odd-mode instability.

Accordingly, embodiments herein can eliminate the need to segment structures such as the drain pad 110 or gate pad 112 by including attenuation structures which allow the risk of odd-mode instability to be reduced without the disadvantages of direct resistive coupling of contact pad segments to each other. In the example of embodiment of FIG. 1, the gate pad 112 is capacitively coupled to resistive stripes 115 which are vertically separated from the gate pad 112 (e.g., disposed beneath the gate pads 112). The resistive stripes 115 are separated from the gate pads 112 and from each other by nonconductive material (e.g., dielectric material).

An advantageous feature of the arrangement of the resistive stripes 115 shown in FIG. 1 is that signals propagating directly from the gate pad 112 to drive the gate fingers 104 (i.e., in the direction indicated by the arrow 195) do not experience additional series resistance. However, because each of the resistive stripes 115 is contiguous in the direction indicated by the arrow 196, when an undesirable electrical signal propagates along that direction (or the direction of signal propagation has a component along that direction) a portion of incident energy drives currents in the resistive stripes 115 and results in resistive losses, thereby attenuating the signal amplitude.

It will be understood that the resistive stripes 115 are a non-limiting example of an acceptable attenuating structure according to embodiments herein. The attenuation experienced by electrical signals due to an attenuation structure such as the resistive stripes 115 may be characterized by an attenuation coefficient that represents a degree of signal attenuation per unit distance (e.g., decibels/meter). It will be appreciated, for example, that the resistive stripes 115 can be characterized along different directions such as the directions indicated, respectively, by the arrows 195 and 196. Because the attenuation structure (i.e., the resistive stripes 115) are discontinuous along the direction of the arrow 195, but provide a set of continuous current paths along the direction of the arrow 196, the attenuation coefficient for signals propagating within the contact pad 112 will be greater along the direction 196 than the direction 195.

Resistive elements such as the resistive stripes 115 may be formed by any suitable methods and from any suitable materials. In one or more embodiments, one or more attenuating structures are metal or metallic stripes. In one or more embodiments, one or more resistive stripes are formed from a semiconductor material that has been suitably doped or otherwise formed to obtain a desired level of electrical conductivity.

In one or more embodiments, resistive elements such as the resistive stripes 115 are metallic stripes with a sheet resistance which is between 10² and 10⁴ times larger than the sheet resistance of a contact pad such as the gate pad 112. In one or more embodiments, resistive elements such as the resistive stripes 115, stripes are formed in a semiconductor material which has sheet resistance between 10³ and 10⁸ times larger than the sheet resistance of a contact electrode such as the gate pad 112.

It will be appreciated that the resistive stripes 115 are non-limiting example of an attenuation structure according to embodiments herein and that different geometries may be employed. For example, a suitable attenuation structure according to embodiments herein can be formed by a set of serpentine structures rather than parallel stripes. Furthermore, an attenuation structure need not be aligned as shown in FIG. 1. For example, although the orientation of the resistive stripes 115 shown in FIG. 1 may be optimal (i.e., having lowest attenuation along the direction of the arrow 195 and greatest attenuation in the direction of the arrow 196), other orientations which provide larger attenuation along the direction of the arrow 196 than along the direction of the arrow 195 can be employed. It will be understood that any structure that exhibits the properties described herein at one or more intended operating frequencies may be employed in attenuation structures according to embodiments herein. For example, structures that are described as electrically contiguous may be formed by discrete elements that behave as continuous structure within a desired frequency range.

In one or more embodiments, a conductive element such as one or more of the resistive stripes 115 has a width in a first direction (e.g., along the direction indicated by the arrow 195) that varies along an orthogonal direction (e.g., the direction indicated by the arrow 196). In one or more such embodiments, this width varies in aperiodic fashion and can reduce the likelihood of undesired electrical resonances.

If desired, attenuation structures such as the resistive stripes 115 can also be used together with previous approaches that employ segmented contact pads. In such applications, the number of pad segments required can be reduced. For example, in one or more embodiments, as illustrated by the inset 199 of FIG. 1, a single gate pad 112 can be replaced with two (or more) gate pads 112. As shown individual gate pads 112 can be separated by a gap 113 and capacitively coupled to resistive stripes 115.

FIG. 2A and FIG. 2B are cross-sectional views of example embodiments along a plane passing through a contact pad 212 (e.g., a gate pad 112 or a drain pad 110). In the arrangement 200A, individual electrically resistive stripes 215 are disposed within a substrate 290 (e.g., the substrate 190) beneath the contact pad 212 and separated from the contact pad 212 by a dielectric material 214 that is electrically insulating. In one or more embodiments, as shown, an attenuating structure such as the resistive stripes 215A may be disposed between the contact pad 212 and an electrically conductive reference plane 224 (e.g., a grounded source terminal coupled to the source fingers 102 via TSVs 108). In one or more embodiments, as shown in the arrangement 200B of FIG. 2B resistive stripes 215B are distributed in two layers and have different widths. It will be understood that the arrangements 200A, 200B are non-limiting examples of attenuating structures according to embodiments herein and that any suitable number and arrangement of electrically resistive elements may be employed.

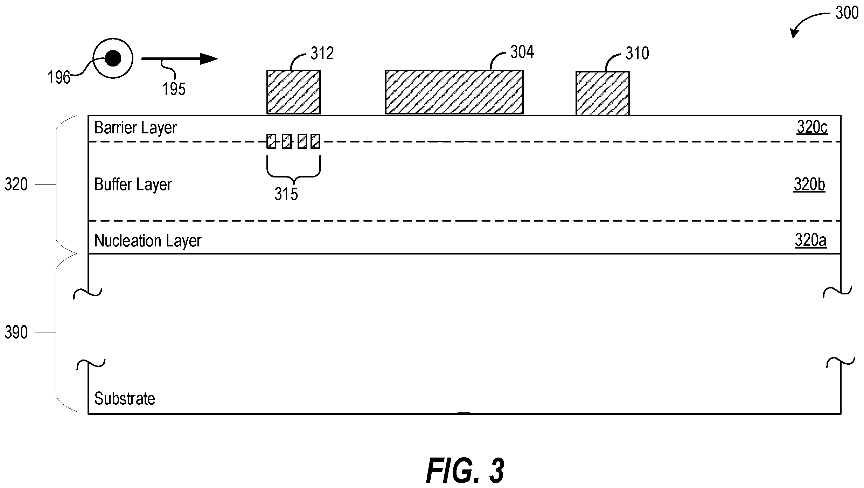

In one or more embodiments, a transistor such as the transistor 101 is a high-electron mobility transistor (HEMT) in which a two-dimensional electron gas ("2DEG") forms a conductive channel controlled by electrodes of gate fingers 304 (e.g., the gate fingers 104). FIG. 3 is simplified cross-sectional view of a HEMT 300 provided with segmented gate contact pads similar to the gate pads 112 according to embodiments herein. The cross-section shown passes through a gate pad 312 (e.g., a gate pad 112), a gate finger 304 (e.g., a gate finger 104), and a drain pad 310 (e.g., a drain pad 110) along the direction indicated by the arrow 195, as in FIG. 1. As shown, the orthogonal direction indicated by the arrow 196 of FIG. 1 is perpendicular to the plane of FIG. 3.

A channel region 320 is formed on or within a substrate 390 from a semiconductor heterostructure that includes three layers which will be described in the context of a GaN HEMT as an example. In this example, the channel region 320 is formed from a nucleation layer 320a (e.g., a layer of aluminum nitride) formed on the substrate 390, followed a by a buffer layer 320b (e.g., an epitaxial layer of gallium nitride), and a barrier layer 320c (e.g., an insulating aluminum nitride/gallium nitride alloy) in which a 2DEG is formed at the interface between the buffer layer 320b and the barrier layer 320c. Typically, for GaN HEMT devices, the substrate 390 may be silicon, silicon carbide, sapphire or any other suitable material. In areas where the presence of a conductive 2DEG is not desirable, one or more of the layers of the channel region 320 can be modified to prevent formation of the 2DEG, rendering the area highly resistive or electrically insulating using any suitable methods, including lithographic patterning, doping, and/or disruption of interfaces via ion implantation, as nonlimiting examples.

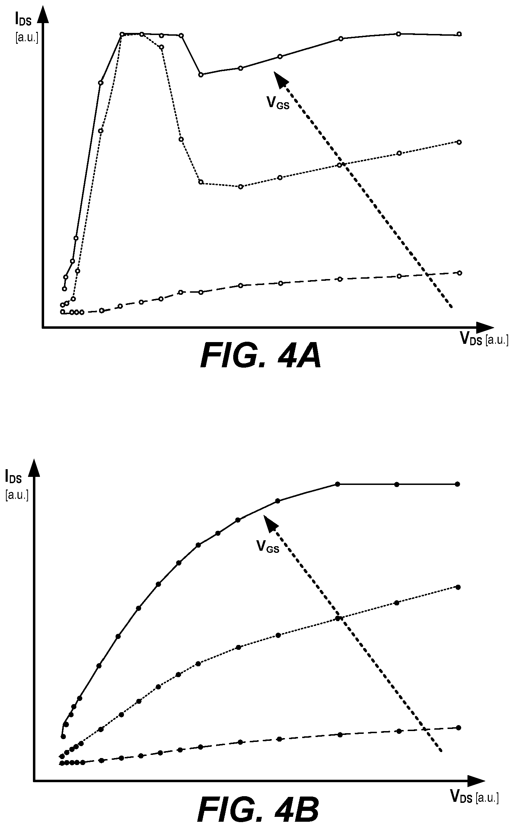

FIG. 4A and FIG. 4B are plots of families of current-voltage characteristics ("IV curves") for two transistor devices with an interdigitated layout related to the layout of the integrated circuit 100 of FIG. 1 and having gate pads similar to the gate pads 112 coupled to resistive stripes similar to the resistive stripes 115. In both FIG. 4A and FIG. 4B, drain-to-source voltage (V_{DS}) is plotted on the horizontal axis, and drain-to-source current (I_{DS}) is plotted on the vertical axis for a series of increasing values of gate-to-source voltage (V_{GS}).

FIG. 4A shows IV curves for increasing values of V_{GS} in a transistor device without any attenuation structure such as the resistive stripes 115, 215A, 215B, 315, and so on. At sufficiently large values of V_{GS}, the IV curves deviate from typical transistor IV curves, exhibiting large increases in I_{DS} with increasing V_{DS}, followed by abrupt equal or larger decreases in I_{DS} with further increasing V_{DS}. This non-monotonic behavior in I_{DS} indicates the presence of odd-mode instability.

Meanwhile, FIG. 4B shows IV curves for a similar device structure to the device of FIG. 4A in which an attenuating structure similar to the resistive stripes 115 is present and coupled to the gate pads of the device similarly to the integrated circuit 100 of FIG. 1. Each of the IV curves for this device exhibit monotonically increasing I_{DS} with increasing V_{DS}, as expected, indicating that the use of an attenuating structure according to embodiments herein can eliminate undesirable odd-mode instabilities.

It will be appreciated that embodiments in which attenuating structures (e.g., resistive stripes 115, 215A, 215B, or 315) are coupled to a gate terminal, input terminal, or other control terminal of a transistor are shown as nonlimiting examples and that nothing herein is intended to limit the use of attenuating structures to any one terminal of a device. In addition, in one or more embodiments two or more terminals of a device each include a corresponding attenuation structure as described herein.

### EXAMPLES

Features of embodiments may be understood by way of one or more of the following examples:
Example 1: An electronic device or method of forming an electronic device that includes a first device region, a contact electrode electrically coupled to the first device region, and an attenuation structure. The first device region is configured to receive an input signal or generate an output signal. The attenuation structure includes one or more electrically resistive structures disposed above or below the contact electrode which are capacitively coupled to the contact electrode. The attenuation structure is also configured to cause anisotropic attenuation of time-varying electrical signals applied to the contact electrode. The attenuation structure is characterized by a first attenuation coefficient along a first direction oriented toward the first device region and the attenuation structure is characterized by a second attenuation coefficient that is greater than the first attenuation coefficient along a second direction that is angularly separated from the first direction.
Example 2: The device or method of Example 1 in which the first device region is an input terminal, an output terminal, or a control terminal of a transistor. The attenuation structure includes a set of resistive stripes that are capacitively coupled to the contact electrode. Each conductive stripe is separated from the contact electrode and separated from each other resistive stripe belonging to the set of resistive stripes by electrically insulating material. Each resistive stripe has a width along the first direction and each resistive stripe is elongated along the second direction.
Example 3: The device or method of Example 2 in which the transistor is a high electron mobility transistor (HEMT) having a channel region formed within a semiconductor heterostructure that is configured to form a conductive two-dimensional electron gas (2DEG). The attenuation structure includes first portions of the semiconductor heterostructure where formation of the 2DEG is prevented and second portions of the heterostructure surrounded by the first portions where the 2DEG forms the one or more electrically-resistive structures.
Example 4: The device or method of any of Examples 1-3 in which the attenuation structure is discontinuous along the first direction and is configured to provide one or more resistive current paths oriented along the second direction.
Example 5: The device or method of any of Examples 1-4 in which the attenuation structure includes a first resistive element formed from a volume of semiconductor material and a second resistive element formed from a metal.
Example 6: The device or method of any of Examples 1-5 in which the attenuation structure includes a first electrically-resistive element vertically separated from the contact electrode and a second electrically-resistive element vertically separated from both the first electrically-resistive element and the contact electrode.
Example 7: The device or method of any of Examples 1-6 in which the contact electrode includes a first section and a second section that is physically separated from the first section by a gap. The attenuation structure is vertically separated from the first section and the second section of the contact electrode. The attenuation structure is capacitively coupled to the first section and to the second section of the contact electrode.
Example 8: The device or method of any of Examples 1-7 in which the attenuation structure includes one or more electrically-resistive elements having a width along the first direction that varies along the second direction.
Example 9: The device or method of any of Examples 1-8: in which the attenuation structure includes one or more electrically-resistive elements having a width along the first direction that varies aperiodically along the second direction.
Example 10: An electronic device or method of forming an electronic device that includes a transistor formed within a semiconductor substrate having three terminals; a contact electrode that is electrically coupled to a first terminal of the transistor that is an input terminal or an output terminal of the transistor; and an attenuation structure formed above or beneath the contact electrode. The attenuation structure includes a set of resistive stripes that are capacitively coupled to the contact electrode. Each conductive stripe is separated from the contact electrode and separated from each other resistive stripe belonging to the set of resistive stripes by electrically insulating material. Each resistive stripe has a width in a first direction oriented toward the first terminal of the transistor and each is elongated along a second direction that is angularly separated from the second direction. The attenuation structure is configured to cause direction-dependent attenuation of time-varying electrical signals that is higher along the second direction than the first direction.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent example functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one example arrangement of elements, additional intervening elements, devices, features, or components may be present in one or more embodiments of the depicted subject matter.

## Claims

1. An electronic device comprising:
a first device region configured to receive an input signal or generate an output signal;
a contact electrode coupled to the first device region; and
an attenuation structure comprising one or more electrically resistive structures disposed above or below the contact electrode and capacitively coupled to the contact electrode;
wherein the attenuation structure is configured to cause anisotropic attenuation of time-varying electrical signals applied to the contact electrode;
wherein the attenuation structure is **characterized by** a first attenuation coefficient along a first direction oriented toward the first device region; and
wherein the attenuation structure is **characterized by** a second attenuation coefficient that is greater than the first attenuation coefficient along a second direction that is angularly separated from the first direction.

2. The device of claim 1,
wherein the first device region is an input terminal, an output terminal, or a control terminal of a transistor;
wherein the attenuation structure comprises a set of resistive stripes that are capacitively coupled to the contact electrode, wherein each conductive stripe is separated from the contact electrode and separated from each other resistive stripe belonging to the set of resistive stripes by electrically insulating material; and
wherein each resistive stripe has a width along the first direction and each resistive stripe is elongated along the second direction.

3. The electronic device of claim 1 or 2,
wherein the transistor is a high-electron mobility transistor, HEMT, having a channel region formed within a semiconductor heterostructure that is configured to form a conductive two-dimensional electron gas, 2DEG; and
wherein the attenuation structure comprises first portions of the semiconductor heterostructure where formation of the 2DEG is prevented and second portions of the heterostructure surrounded by the first portions where the 2DEG forms the one or more electrically-resistive structures.

4. The electronic device of any preceding claim, wherein the attenuation structure is discontinuous along the first direction and is configured to provide one or more resistive current paths oriented along the second direction that is angularly separated from the first direction.

5. The electronic device of any preceding claim, wherein the attenuation structure includes a first resistive element formed from a volume of semiconductor material and a second resistive element formed from a metal.

6. The electronic device of any preceding claim
wherein the attenuation structure includes a first electrically-resistive element vertically separated from the contact electrode and a second electrically-resistive element vertically separated from both the first electrically-resistive element and the contact electrode.

7. The electronic device of any preceding claim,
wherein the contact electrode includes a first section and a second section that is physically separated from the first section by a gap; and
wherein the attenuation structure is vertically separated from the first section and the second section of the contact electrode and the attenuation structure is capacitively coupled to the first section and to the second section of the contact electrode.

8. The electronic device of any preceding claim,
wherein the attenuation structure includes one or more electrically-resistive elements having a width along the first direction that varies along the second direction.

9. A method of forming an electronic device comprising:
forming a contact electrode coupled to a first device region configured to receive an input signal or generate an output signal; and
forming an attenuation structure that includes one or more electrically resistive structures disposed above or below the contact electrode and capacitively coupled to the contact electrode;
wherein the attenuation structure is configured to cause anisotropic attenuation of time-varying electrical signals applied to the contact electrode;
wherein the attenuation structure is **characterized by** a first attenuation coefficient along a first direction oriented toward the first device region; and
wherein the attenuation structure is **characterized by** a second attenuation coefficient that is greater than the first attenuation coefficient along a second direction that is angularly separated from the first direction.

10. The method of claim 9,
wherein the first device region is an input terminal, an output terminal, or a control terminal of a transistor;
wherein forming the attenuation structure comprises forming a set of resistive stripes that are capacitively coupled to the contact electrode, wherein each conductive stripe is separated from the contact electrode and separated from each other resistive stripe belonging to the set of resistive stripes by electrically insulating material; and
wherein each resistive stripe has a width along the first direction oriented along the first direction and each resistive stripe is elongated along the second direction.

11. The method of claim 9 or 10, wherein the attenuation structure is discontinuous along the first direction and is configured to provide one or more resistive current paths oriented along the second direction that is angularly separated from the first direction.

12. The method any one of claims 9 to 11, wherein forming the attenuation structure comprises forming a first electrically-resistive element from a volume of semiconductor material and a forming second electrically-resistive element from a metal.

13. The method any one of claims 9 to 12,
wherein forming attenuation structure includes forming a first electrically-resistive element vertically separated from the contact electrode and forming a second electrically-resistive element vertically separated from both the first electrically-resistive element and the contact electrode.

14. The method any one of claims 9 to 13,
wherein the contact electrode includes a first section and a second section that is physically separated from the first section by a gap; and
wherein the attenuation structure is vertically separated from the first section and the second section of the contact electrode and the attenuation structure is capacitively coupled to the first section and capacitively coupled to the second section of the contact electrode.

15. The method any one of claims 9 to 14,
wherein the attenuation structure includes one or more electrically-resistive elements having a width along the first direction that varies along the second direction.
